# EUROPEAN PATENT APPLICATION

(11) **EP 4 709 110 A2**
(43) Date of publication of application: **11.03.2026**
(21) Application number: 24849325.6
(22) Date of filing: 11.04.2024
(51) Int. Cl.: H10H 29/01, H01L 25/075, H10H 20/85, H10H 20/851, H10H 20/855, H10H 20/853

(54) **DISPLAY DEVICE AND MANUFACTURING METHOD THEREOF**

(30) Priority: 02.08.2023 KR 20230100863
(71) Applicant: Samsung Electronics Co., Ltd., Suwon-si, Gyeonggi-do 16677 (KR)
(72) Inventor: SOHN, Sanghyun, Suwon-si Gyeonggi-do 16677 (KR); PARK, Yeseul, Suwon-si Gyeonggi-do 16677 (KR); KOH, Sungjun, Suwon-si Gyeonggi-do 16677 (KR)
(74) Representative: Appleyard Lees IP LLP
(86) International application number: PCT/KR2024/004798
(87) International publication number: WO 2025/028753

(57) **Abstract**

A display device includes a lower substrate comprising at least one light-emitting diode (LED) light source, an upper substrate comprising at least one quantum dot color filter, and a bonding layer configured to bond the lower substrate and the upper substrate. The upper substrate may include a partition wall structure including least one sub-rod is repeatedly provided in an edge area of a partition wall layer.

## Description

### [Technical Field]

The disclosure relates to a display device including a color filter and a method for manufacturing the same.

### [Background Art]

Display devices are devices that process image signals and/or image data inputted from an external source or stored internally after being processed. Display devices display the processed image signals and/or image data as images on a display panel or screen and may be implemented on various displays, such as televisions, monitors, or portable media players.

Display devices may include a lower substrate including a plurality of pixels and an upper substrate including a color filter and a color conversion unit to enhance display quality. For example, the color conversion unit may convert the wavelength of light provided from the lower substrate. Accordingly, the display device, including the color conversion unit, may emit light having a different color from the incident light. For example, the color conversion unit may include wavelength conversion particles such as quantum dots.

Wavelength conversion particles, such as quantum dots, may be deteriorated due to impurities penetrating into the display device. When the quantum dots deteriorate, the display device may experience deterioration of display quality due to uneven luminance.

### [Disclosure of Invention]

### [Technical Problem]

Provided is a display device which may prevent deterioration of quantum dots by minimizing impurities penetrating through a partition wall structure, and a method for manufacturing the same.

Additional aspects will be set forth in part in the description which follows and, in part, will be apparent from the description, or may be learned by practice of the presented embodiments.

### [Solution to Problem]

According to an aspect of the disclosure, a display device may include a lower substrate comprising at least one light-emitting diode (LED) light source, an upper substrate comprising at least one quantum dot color filter, and a bonding layer configured to bond the lower substrate and the upper substrate. The upper substrate may include a partition wall structure which comprises a plurality of sub-rods that are repeatedly provided in an edge area of a partition wall layer.

The at least one of the plurality of sub-rods may be configured to prevent penetration of an impurity including at least one of oxygen or moisture through the edge area.

The upper substrate may include a glass substrate configured to output light, a black matrix layer configured to prevent light interference, a color filter layer which comprises at least one quantum dot color filter, a color conversion layer which comprises at least one color converter, the partition wall layer which comprises at least one of the plurality of sub-rods, and an inorganic encapsulation layer configured to control light reflection.

The lower substrate may include a base substrate, a buffer layer including an inorganic insulation material, and a light-emitting element layer including the at least one LED light source.

The bonding layer may include an optical bonding material configured to transmit light and the bonding layer may be configured to bond the lower substrate and the upper substrate using the optical bonding material.

In the partition wall structure, the plurality of sub-rods may be repeatedly provided at intervals of 1 µm to 100 µm.

The at least one of the plurality of sub-rods of the partition wall structure has a cubic shape and may be formed to have a height of 1 µm to 100 µm.

The inorganic encapsulation layer may be configured to fill an engraved area between at least two of the plurality of sub-rods and may be configured to be parallel to the black matrix layer.

The upper substrate may further include a functional planarization layer provided between the color filter layer and the partition wall layer and the functional planarization layer includes a low refractive material.

The plurality of sub-rods may be repeatedly provided between at least two quantum dot color filters.

According to an aspect of the disclosure, a method for manufacturing a display device may include forming a light-emitting substrate comprising at least one LED light source, forming a color conversion substrate comprising at least one quantum dot color filter, and forming a bonding layer bonding the light-emitting substrate and the color conversion substrate. Here, forming the color conversion substrate may include forming a partition wall structure which comprises a plurality of sub-rods that may be repeatedly provided in an edge area of a partition wall layer.

The partition wall structure may include the at least one of the plurality of sub-rods for preventing penetration of an impurity including at least one of oxygen and moisture through the edge area.

The forming the color conversion substrate may include: forming a glass substrate outputting light; forming a black matrix layer preventing light interference; forming a color filter layer comprising at least one quantum dot color filter; forming a color conversion layer comprising at least one color converter; forming the partition wall layer comprising at least one of the plurality of sub-rods; and forming an inorganic encapsulation layer controlling light reflection.

The forming the light-emitting substrate may include: forming a base substrate; forming a buffer layer comprising an inorganic insulating material; and forming a light-emitting element layer comprising at least one LED light source.

The bonding layer may include an optical bonding material transmitting light and bonds the light-emitting substrate and the color conversion substrate using the optical bonding material.

In the partition wall structure, the plurality of sub-rods may be repeatedly provided at intervals of 1 µm to 100 µm.

The at least one sub-rod of the partition wall structure may have a cubic shape and may be formed to have a height of 1 µm to 100 µm.

The forming the inorganic encapsulation layer may include filling an engraved area between at least two sub-rods and forming the inorganic encapsulation layer parallel to the black matrix layer.

The forming the color conversion substrate may further include forming a functional planarization layer provided between the color filter layer and the partition wall layer and including a low refractive material.

The plurality of sub-rods may be repeatedly provided between at least two quantum dot color filters.

### [Advantageous Effects of Invention]

According to various embodiments of the disclosure, the display device and method for manufacturing the same according to the disclosure may prevent deterioration of quantum dots by minimizing impurities penetrating inside through the partition wall structure. Therefore, the display device and method for manufacturing the same according to the disclosure may secure reliable display quality and increase luminance uniformity.

Effects of the disclosure are not limited to the foregoing, and other unmentioned effects would be apparent to one of ordinary skill in the art from the following description. In other words, unintended effects in practicing embodiments of the disclosure may also be derived by one of ordinary skill in the art from the embodiments of the disclosure.

### [Brief Description of Drawings]

The above and other aspects, features, and advantages of certain embodiments of the disclosure will be more apparent from the following description taken in conjunction with the accompanying drawings, in which:
FIG. 1 is an example plan view illustrating a display device, according to one or more embodiments;
FIG. 2 is an example cross-sectional view illustrating a display device, according to one or more embodiments;
FIG. 3 illustrates an example stacked structure of a display device, according to one or more embodiments;
FIG. 4 illustrates an example stacked structure of a lower substrate, according to one or more embodiments;
FIG. 5 illustrates an example stacked structure of an upper substrate, according to one or more embodiments;
FIGs. 6A and 6B illustrate example display devices in which a lower substrate and an upper substrate are bonded by a bonding layer, according to one or more embodiments
FIG. 7 illustrates an example stacked structure of a display device, according to one or more embodiments;
FIG. 8 illustrates an example stacked structure of a display device, according to one or more embodiments;
FIG. 9 illustrates an example stacked structure of a display device, according to one or more embodiments;
FIG. 10 illustrates an example stacked structure of a display device, according to one or more embodiments;
FIG. 11 illustrates an example stacked structure of a display device, according to one or more embodiments; and
FIG. 12 is an example flowchart illustrating a method for manufacturing a display device, according to one or more embodiments.

### [Mode for the Invention]

Embodiments of the disclosure are described below with reference to the accompanying drawings in such a detailed manner as to be easily practiced by one of ordinary skill in the art. However, the disclosure may be implemented in other various forms and is not limited to the embodiments set forth herein. The same or similar reference denotations may be used to refer to the same or similar elements throughout the disclosure and the drawings.

The following description with reference to the accompanying drawings is provided to assist in a comprehensive understanding of various embodiments of the disclosure as defined by the claims and their equivalents. It includes various specific details to assist in that understanding but these are to be regarded as merely exemplary. Accordingly, those of ordinary skill in the art will recognize that various changes and modifications of the various embodiments described herein can be made without departing from the scope and spirit of the disclosure. In addition, descriptions of well-known functions and constructions may be omitted for clarity and conciseness.

The terms and words used in the following description and claims are limited to the bibliographical meanings but are merely used by the inventor to enable a clear and consistent understanding of the disclosure. Accordingly, it should be apparent to those skilled in the art that the following description of various embodiments of the disclosure is provided for illustration purpose only and not for the purpose of limiting the disclosure as defined by the appended claims and their equivalents.

It will be further understood that the terms "comprise" and/or "have," as used herein, specify the presence of stated features, integers, steps, operations, elements, and/or components, but do not preclude the presence or addition of one or more other features, integers, steps, operations, elements, components, and/or groups thereof.

The term "and/or" may denote a combination(s) of a plurality of related components as listed or any of the components.

Hereinafter, the working principle and embodiments of the disclosure are described with reference to the accompanying drawings.

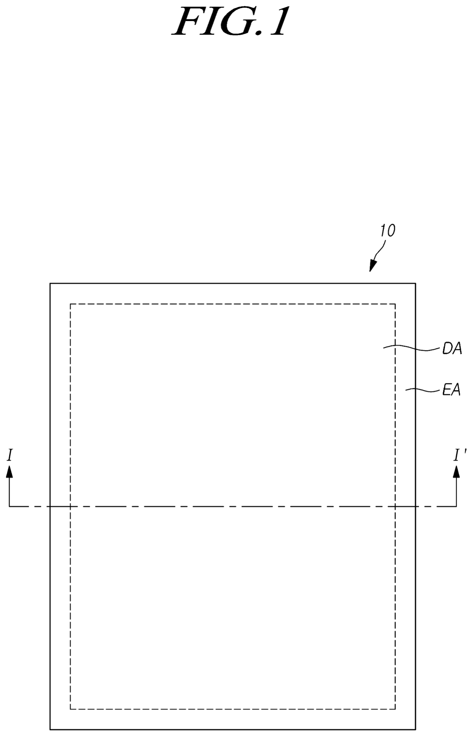

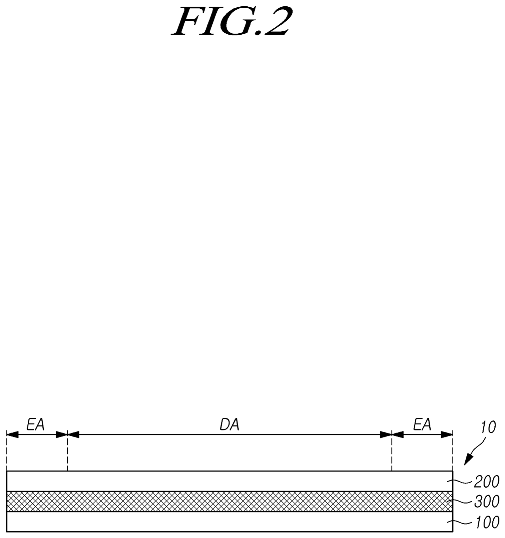

FIG. 1 is an example plan view illustrating a display device 10 according to one or more embodiments. FIG. 2 is an example cross-sectional view illustrating a display device 10 according to one or more embodiments.

Referring to FIG. 1, the display device 10 may include a display area on which an image is displayed, and an edge area disposed outside the display area. For example, the edge area may surround the display area on a plane.

To provide the image display function according to an example embodiment of the disclosure, the display device 10 may include a display panel, where a plurality of data lines and a plurality of gate lines are arranged, and a plurality of subpixels, defined by the plurality of data lines and the plurality of gate lines that are arranged, a data driving circuit for driving the plurality of data lines, a gate driving circuit for driving the plurality of gate lines, and a display controller for controlling the data driving circuit and the gate driving circuit.

The data driving circuit, the gate driving circuit, and the display controller each may be implemented as one or more individual components. In some cases, two or more of the data driving circuit, the gate driving circuit, and the display controller may be integrated into a single component. For example, the data driving circuit and the display controller may be implemented as a single integrated circuit (IC) chip.

Specifically, to provide a touch sensing function according to an example embodiment of the disclosure, the display device 10 may include a touch panel (e.g., touch screen panel) having a plurality of touch electrodes, and a touch sensing circuit for supplying touch driving signals to the touch panel, detecting touch sensing signals from the touch panel, and determining whether there is a user's touch (e.g., user's input) and/or the position of a touch (touch coordinates) on the touch panel based on the detected touch sensing signals.

For example, the touch sensing circuit may include at least one of a touch driving circuit for supplying a touch driving signal to the touch panel and detecting a touch sensing signal from the touch panel, and a touch controller for detecting the presence or absence of the user's touch and the position of touch on the touch panel based on the touch sensing signal detected by the touch driving circuit.

The touch driving circuit may include a first circuit part for supplying a touch driving signal to the touch panel and a second circuit part for detecting a touch sensing signal from the touch panel. The touch driving circuit and the touch controller may be implemented as separate (or independent) components or may be integrated and implemented as one component.

Each of the data driving circuit, gate driving circuit, and touch driving circuit may be implemented as one or more ICs and as a chip-on-glass type, a chip-on-film type, or a tape carrier package type in relation to the display panel and electrical connection. The gate driving circuit may also be implemented in a gate-in-panel type.

Each of the circuit components for driving the display and for touch sensing (e.g., detecting signal input) may be implemented as one or more individual components. In some cases, one or more of the circuit components for display driving and one or more of the circuit components for touch sensing may be functionally integrated and implemented as one or more components.

For example, the data driving circuit and the touch driving circuit may be implemented by being integrated into one or more IC chips. If the data driving circuit and the touch driving circuit are integrated into two or more IC chips, each of the two or more IC chips may have a data driving function and a touch driving function.

Referring to FIG. 2, the display device 10 may include a lower substrate 100, an upper substrate 200, and a bonding layer 300. For example, referring to FIG. 2, a bottom side of the upper substrate 200 may be disposed to face a top side of the lower substrate 100 and may be positioned in a first direction. For example, the first direction may be a direction facing or opposing the front of the display device 10 with respect to the lower substrate 100. The bonding layer 300 may be connected or bonded to the upper side of the lower substrate 100 and the bottom side of the upper substrate 200.

The lower substrate 100 may include a plurality of LED light sources. The LED light sources may be disposed in a display area of the lower substrate 100. Each of the LED light sources may include a driving element and a light-emitting element. The driving device may include at least one thin film transistor. The light-emitting device may generate light according to a driving signal. For example, the light-emitting device may be an organic or inorganic LED.

The upper substrate 200 may include a color conversion unit (or color converter). The color conversion unit may be disposed in the display area and configured to convert a wavelength of light generated from the light-emitting element of the lower substrate 100. The upper substrate 200 may include a color filter layer 230 that transmits light of a specific color.

The bonding layer 300 may be bonded or attached to the lower substrate 100 and the upper substrate 200. The bonding layer 300 may be disposed in a bonding area between the lower substrate 100 and the upper substrate 200. For example, the bonding layer 300 may have a planar shape including a bonding material. However, embodiments of the disclosure are not limited thereto, and the bonding layer 300 may have various planar shapes according to the planar shape of the lower substrate 100 or the upper substrate 200. For example, if the lower substrate 100 or the upper substrate 200 has a planar shape, such as a triangle, a rhombus, a polygon, a circle, or an ellipse, the bonding layer 300 may have a planar shape, such as a hollow triangle, a hollow rhombus, a hollow polygon, a hollow circle, or a hollow ellipse.

In an example embodiment, the bonding layer 300 may include a filler. For example, the filler may provide a buffer to external pressure applied to the display device 10. For example, the filler may maintain a gap between the lower substrate 100 and the upper substrate 200.

The display device 10 may include a partition wall structure (PWS) for preventing impurities from penetrating into the display device 10. The display device 10 may prevent deterioration of quantum dots by minimizing impurities from penetrating or entering into the display device 10 through the PWS. Accordingly, the display device 10 may increase uniformity of luminance and secure reliability of display quality.

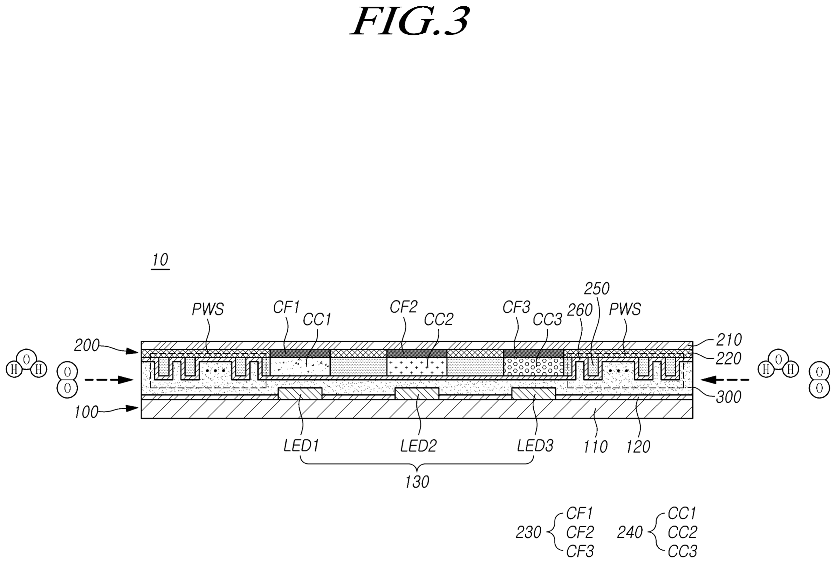

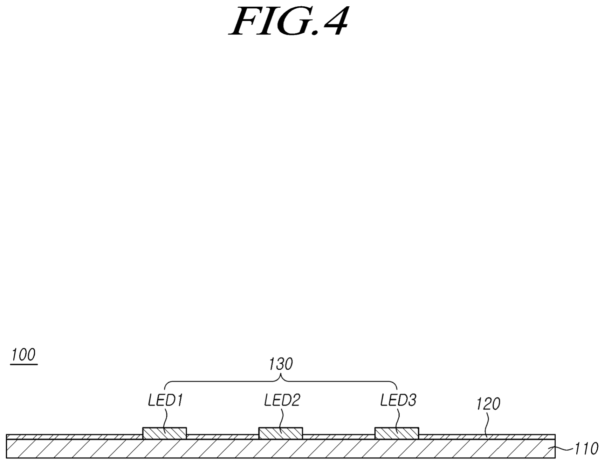

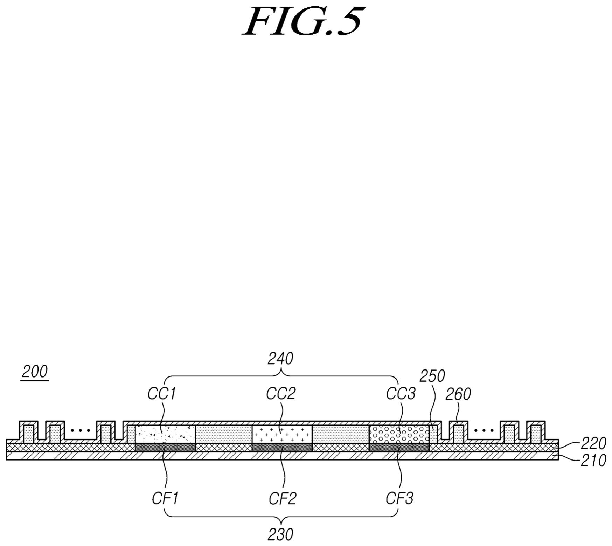

FIG. 3 illustrates an example stacked structure of a display device 10 according to one or more embodiments, FIG. 4 illustrates an example stacked structure of a lower substrate 100 according to one or more embodiments, and FIG. 5 illustrates an example stacked structure of an upper substrate 200 according to one or more embodiments.

Referring to FIG. 3, the display device 10 may include a lower substrate 100 including at least one LED light source, an upper substrate 200 including at least one quantum dot color filter, and a bonding layer 300 bonding the lower substrate 100 and the upper substrate 200. For example, the bonding layer 300 may be formed on the lower substrate 100. For example, the upper substrate 200 may be formed on the bonding layer 300.

In an embodiment, the upper substrate 200 may include a PWS in which at least one sub-rod is repeatedly disposed in an edge area of the partition wall layer 250. The PWS may include the at least one sub-rod to prevent impurities including at least one of oxygen O₂ and moisture H₂O from penetrating through the edge area.

As illustrated in FIG. 4, the lower substrate 100 may include a base substrate 110, a buffer layer 120 including an inorganic insulating material, and a light-emitting device layer 130 including the at least one LED light source. For example, the lower substrate 100 may be a light-emitting substrate.

The base substrate 110 may be a substrate having a basic structure of the lower substrate 100. The base substrate 110 may be an insulating substrate formed of a transparent or opaque material. For example, the base substrate 110 may be at least one of a glass substrate, a plastic substrate, and a silicon substrate. If the base substrate 110 is a glass substrate, the base substrate 110 may be a rigid substrate. If the base substrate 110 is a plastic substrate, the base substrate 110 may be a flexible substrate.

The buffer layer 120 may include an inorganic insulating material such as a silicon compound or a metal oxide. For example, the buffer layer 120 may include at least one of silicon oxide (SiO), silicon nitride (SiN), silicon oxynitride (SiON), silicon oxynitride (SiOC), silicon carbide (SiCN), aluminum oxide (AlO), aluminum nitride (AlN), tantalum oxide (TaO), hafnium oxide (HfO), zirconium oxide (ZrO), and titanium oxide (TiO). The buffer layer 120 may have a single layer structure or a multilayer structure including a plurality of insulating layers.

The light-emitting device layer may generate light on the lower substrate 100. The light-emitting element layer may include at least one LED light source (e.g., LED1, LED2, and LED3). For example, the at least one LED light source may include micro-LEDs that emit different colors (e.g., red, blue, and green). For example, the at least one LED light source may include blue micro-LEDs that emit the same light (e.g., blue). Each of the at least one LED light source may include a driving element and a light-emitting element. The driving device may include at least one thin film transistor. The light-emitting device may generate light according to a driving signal. For example, the light-emitting device may be an organic or inorganic LED.

As shown in FIG. 5, the upper substrate 200 may include a glass substrate 210 for outputting light, a black matrix layer 220 for preventing interference of light, a color filter layer 230 having at least one quantum dot color filter, a color conversion layer 240 having at least one color conversion unit (or color converter), the partition wall layer 250 having at least one sub-rod, and an inorganic encapsulation layer 260 for controlling reflection of light. For example, the upper substrate 200 may be a color conversion substrate.

The glass substrate 210 may output light generated by the lower substrate 100 to the outside. For example, the glass substrate 210 may be formed of a transparent material (e.g., glass).

The black matrix layer 220 may be formed on the glass substrate 210. For example, the black matrix layer 220 may be formed on the glass substrate 210. The black matrix layer 220 may prevent interference of light generated by the lower substrate 100. For example, the black matrix layer 220 may absorb light to minimize reflection, thereby increasing the luminance of the output light.

The color filter layer 230 may be formed on the black matrix layer 220. For example, the color filter layer 230 may be formed on the black matrix layer 220. The color filter layer 230 may include at least one quantum dot color filter (e.g., CF1, CF2, or CF3). The color filter layer 230 may include at least one of a red color filter CF1, a green color filter CF2, and a blue transmission layer CF3. The red color filter CF1 may block blue light and transmit red light. The green color filter CF2 may block blue light and transmit green light. The blue transmission layer CF3 may transmit the input blue light.

The color conversion layer 240 may be formed on the color filter layer 230. The color conversion layer 240 may include at least one color conversion unit (e.g., CC1, CC2, and CC3). At least one color conversion unit may be formed on at least one quantum dot color filter. For example, at least one color conversion unit may be disposed in each of the openings of the partition wall layer 250. The color conversion layer 240 may include quantum dots that change the wavelength of incident light. For example, the first color conversion unit CC1 may include red quantum dots dispersed in the resin. For example, the second color conversion unit CC2 may include green quantum dots dispersed in the resin. The third color conversion unit CC3 may include a transparent resin.

The partition wall layer 250 may be formed on the color filter layer 230. For example, the partition wall layer 250 may be formed on the color filter layer 230. The partition wall layer 250 may be configured to minimize light leakage. The partition wall layer 250 may include an organic material. The partition wall layer 250 may further include a light blocking material. For example, at least a portion of the partition wall layer 250 may include a light blocking material such as a black pigment, a dye, or carbon black.

The partition wall layer 250 may include the at least one sub-rod in an edge area. Since sub-rod(s) may be repeatedly formed in the edge area of the partition wall layer 250 at predetermined intervals, the upper substrate 200 may include a partition wall structure.

The inorganic encapsulation layer 260 may be formed on the partition wall layer 250, for example, by at least one of plasma-enhanced chemical vapor deposition and chemical vapor deposition. The inorganic encapsulation layer 260 may include an inorganic material, such as SiOxNx, SiNx, or SiO. The inorganic encapsulation layer 260 may enhance color precision of light output to the outside by controlling reflection of light.

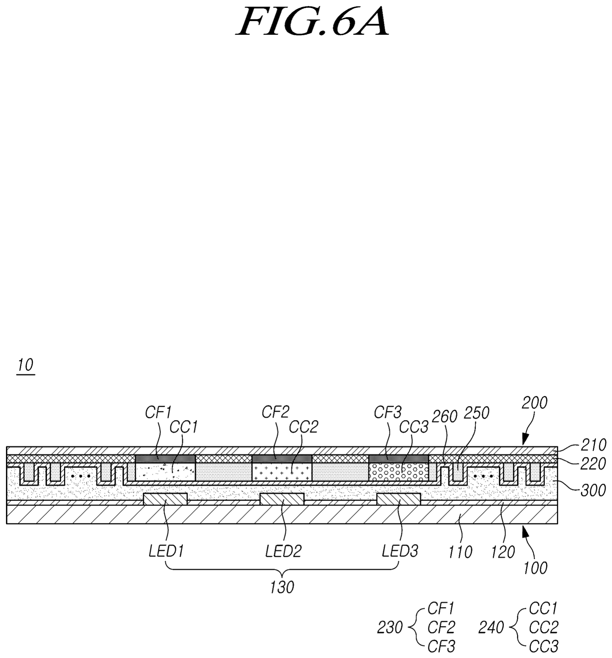

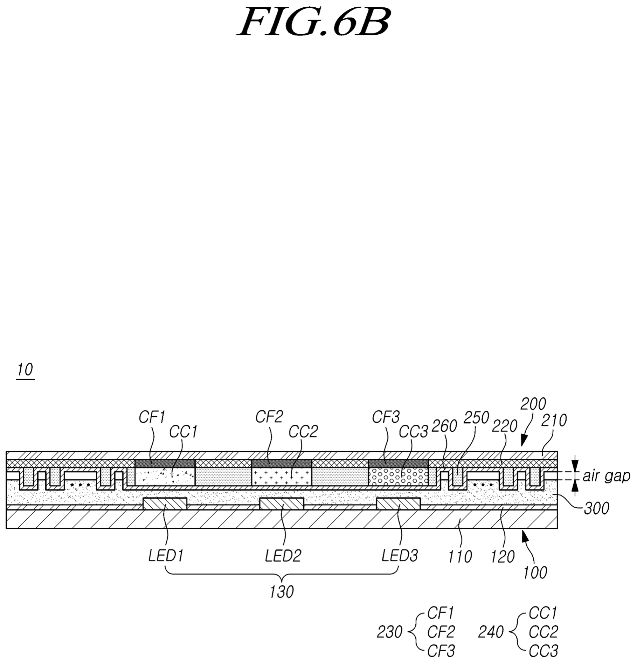

FIGs. 6A and 6B illustrate example display devices 10 in which a lower substrate 100 and an upper substrate 200 are bonded by a bonding layer 300 according to one or more embodiments.

Referring to FIGs. 6A and 6B, the bonding layer 300 may include an optical bonding material and bonded to the lower substrate 100 and the upper substrate 200 using the optical bonding material.

For example, the bonding layer 300 may have optical transparency. The bonding layer 300 may preserve optical properties of light output from the lower substrate 100 by maximizing light transmission and minimizing light reflection.

For example, the optical bonding material may fill the bonding area between the lower substrate 100 and the upper substrate 200. For example, the optical bonding material may include at least one of an epoxy adhesive, an acrylic adhesive, a silicone adhesive, a melamine adhesive, a UV-curable adhesive, a hot melt adhesive, or a polyurethane adhesive.

As shown in FIG. 6A, the bonding material of the bonding layer 300 may fill the whole bonding areas. For example, the bonding material may be in contact with (or touch) each of the lower substrate 100 and the upper substrate 200 and may be bonded or attached to the lower substrate 100 and the upper substrate 200.

In an embodiment, as shown in FIG. 6B, the bonding material of the bonding layer 300 may fill only a portion of the bonding area. For example, the bonding layer 300 may include an air gap, which is not filled with the bonding material. The bonding layer 300 may be in contact with the lower substrate 100 and may not be in contact with a portion of the upper substrate 200.

The display device 10 may include a PWS for preventing impurities from penetrating or entering into the display device 10. The display device 10 may prevent deterioration of quantum dots by minimizing impurities penetrating into the display device 10 through the PWS.

The upper substrate 200 may include a PWS in which at least two sub-rods may be repeatedly disposed in an edge area of the partition wall layer 250. The PWS may include the at least one sub-rod to prevent impurities including at least one of oxygen O₂ and moisture H₂O from penetrating or entering through the edge area.

For example, in the PWS, the at least two sub-rods may be repeatedly arranged at intervals between 1 µm and 100 µm. The intervals between the at least one sub-rod may be the same. The intervals between the at least one sub-rod may be different from each other. The PWS may include an engraved area according to the interval between at least two sub-rods.

In an example embodiment, the at least one sub-rod of the PWS may have a cubic shape and be formed to have a height of 1 µm to 100 µm. For example, the at least one sub-rod may be a cube having a length of a side in a range between 1 µm and 100 µm. However, the shape and size of the sub-rod included in the display device 10 of the disclosure are not limited thereto.

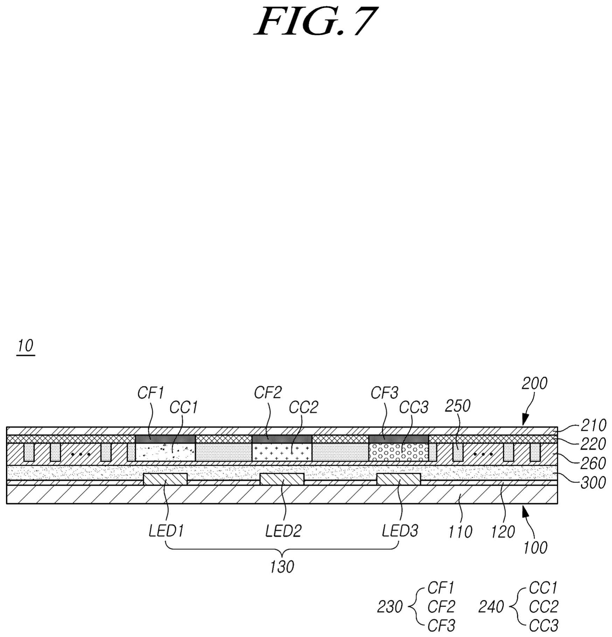

FIG. 7 illustrates an example stacked structure of a display device 10 according to one or more embodiments.

Referring to FIG. 7, the display device 10 may include an upper substrate 200 including a PWS. The PWS may include an engraved area according to the interval between at least two sub-rods.

In an embodiment, the inorganic encapsulation layer 260 may fill the engraved area between the at least two sub-rods. For example, the inorganic encapsulation layer 260 may fill the engraved area and may be formed in a structure parallel to the black matrix layer 220.

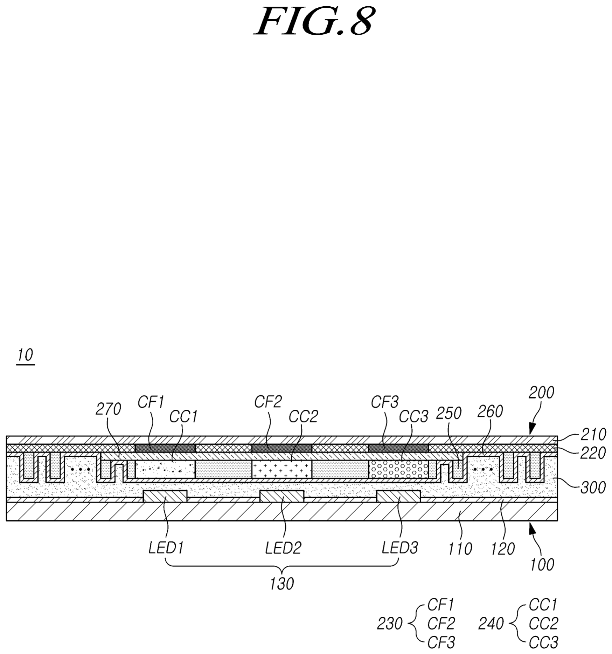

FIG. 8 illustrates an example stacked structure of a display device 10 according to one or more embodiments.

Referring to FIG. 8, the display device 10 may include an upper substrate 200 including a PWS. The upper substrate 200 may further include a functional planarization layer 270 disposed between the color filter layer 230 and the partition wall layer 250. For example, the display device 10 may further include the functional planarization layer 270, thereby enhancing the refractive index of light and increasing the luminance of output light.

The functional planarization layer 270 may reduce or eliminate a step difference caused by the color filter layer 230. The functional planarization layer 270 may include an organic and/or an inorganic material. For example, the functional planarization layer may include at least one of silicon oxide and silicon nitride.

The functional planarization layer 270 may include a low refractive material having a refractive index ranging from 1.0 to 1.6. For example, the functional planarization layer 270 may include hollow particles. For example, the hollow particles may include an inorganic material. The hollow particles may be dispersed in the resin matrix. For example, the hollow particles may include at least one of silica (SiO₂), magnesium fluoride (MgF₂), and iron oxide (Fe₃O₄). For example, the resin matrix may include an acrylic resin, a siloxane resin, a urethane resin, or an imide resin and may be selected in consideration of refractive index and processibility.

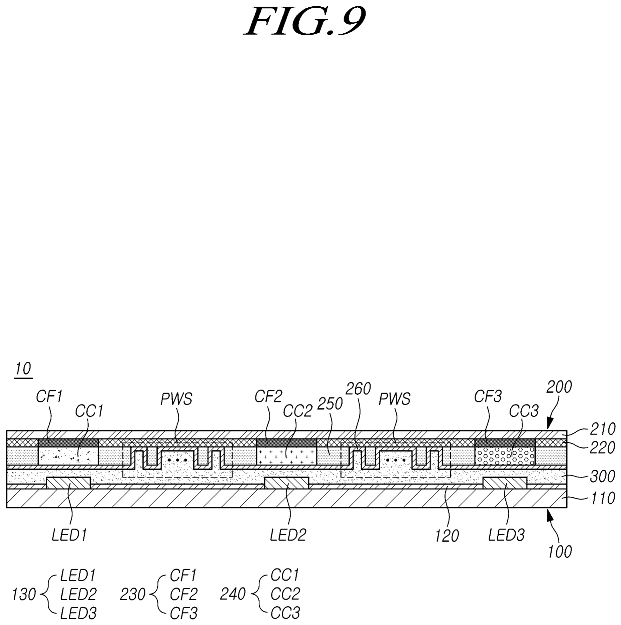

FIG. 9 illustrates an example stacked structure of a display device 10 according to one or more embodiments.

Referring to FIG. 9, the display device 10 may include an upper substrate 200 including a PWS. The PWS may be formed between quantum dot color filters. For example, the upper substrate 200 may include the PWS in which the sub-rods are repeatedly disposed between a plurality of quantum dot color filters.

If the PWS is formed between the quantum dot color filters, deterioration of quantum dots, due to impurities introduced between the quantum dot color filters, may be minimized. For example, the sub-rods may be repeatedly arranged between quantum dot color filters at intervals of 1 µm to 100 µm.

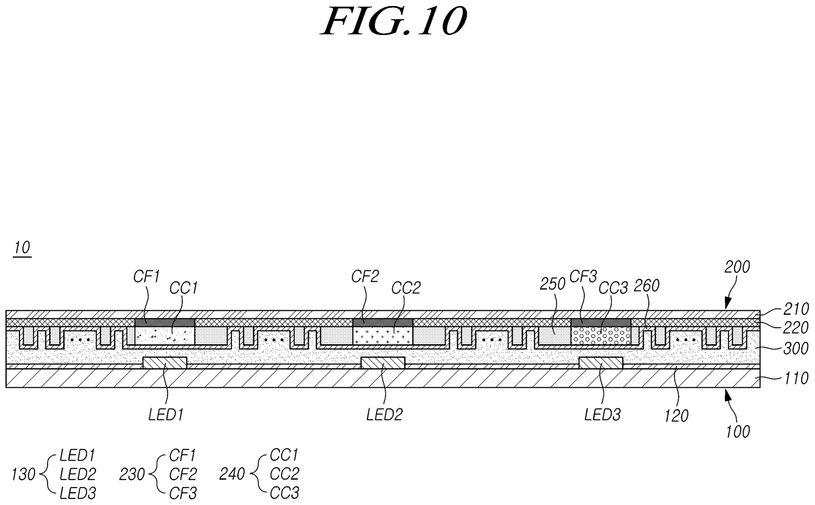

FIG. 10 illustrates an example stacked structure of a display device 10 according to one or more embodiments.

Referring to FIG. 10, the display device 10 may include an upper substrate 200 including a PWS. The PWS may be formed in each of an edge area and a display area. For example, the PWS may be formed between the edge area of the partition wall layer 250 and the quantum dot color filter.

If the PWS is formed in the edge area and the display area, the PWS may prevent the impurities introduced into the edge area and between the quantum dot color filters.

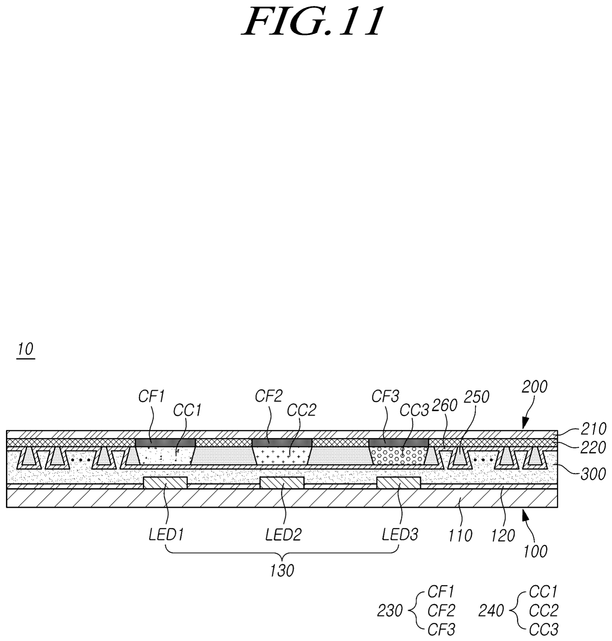

FIG. 11 illustrates an example stacked structure of a display device 10 according to one or more embodiments. Referring to FIG. 11, the display device 10 may include an upper substrate 200 including a PWS. For example, the PWS may include sub-rods of various shapes and sizes.

In one example configuration, a sub-rod may have a trapezoidal shape. However, the shape of the sub-rod is not limited to the trapezoidal shape, and the shape of the sub-rod may have various shapes, including a circle, a triangle, an ellipse, and a combination thereof.

Further, as shown in FIG. 11, the inorganic encapsulation layer 260 may be formed in a shape corresponding to the shape of the sub-rod as the sub-rod of the PWS has various shapes.

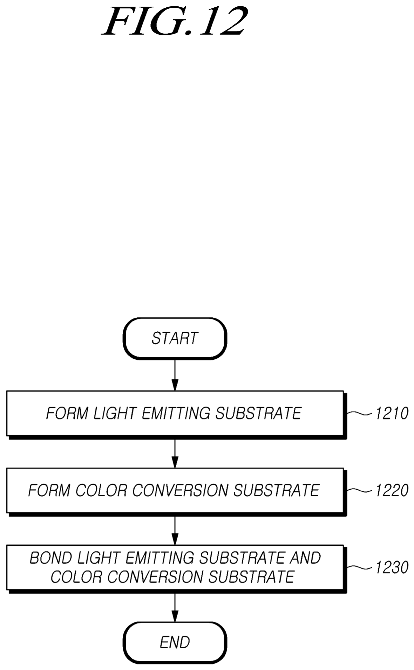

FIG. 12 is an example flowchart illustrating a method for manufacturing a display device according to one or more embodiments.

Referring to FIG. 12, a method for manufacturing a display device according to the disclosure may form a light-emitting substrate (e.g., 100) (step 1210), form a color conversion substrate (e.g., 200) (step 1220), and bond the light-emitting substrate (e.g., 100) and the color conversion substrate (e.g., 200) (step 1230). In particular, the method of manufacturing the display device may form a PWS in which a plurality of sub-rods may be repeatedly disposed in an edge area of the partition wall layer 250. The PWS may include the at least one sub-rod to prevent impurities including at least one of oxygen and moisture from penetrating through the edge area.

According to an embodiment, in step 1210, the method of manufacturing the display device 10 may form a light-emitting substrate 100 including at least one LED light source.

The method for manufacturing the display device may include forming a base substrate 110, forming a buffer layer 120 including an inorganic insulating material, and forming a light-emitting device layer 130 including the at least one LED light source.

According to an embodiment, in step 1220, the method of manufacturing the display device may form a color conversion substrate 200 including at least one quantum dot color filter.

In the method for manufacturing the display device 10, the color conversion substrate 200 may be formed to include a glass substrate 210 for outputting light, a black matrix layer 220 may be formed for preventing interference of light, a color filter layer 230 may be formed to include the at least one quantum dot color filter, the partition wall layer 250 may be formed to include the at least one sub-rod, and an inorganic encapsulation layer 260 may be formed for controlling reflection of light.

For example, a plurality of sub-rods may be repeatedly arranged at intervals between 1 µm and 100 µm on the PWS. For example, at least one sub-rod may have a cubic shape and may be formed in a height range of 1 µm to 100 µm.

According to an example embodiment, in step 1230, the method of manufacturing the display device 10 may form a bonding layer 300 for bonding the light-emitting substrate 100 and the color conversion substrate 200. For example, the bonding layer 300 may include an optical bonding material and bond the light-emitting substrate 100 and the color conversion substrate 200 using the optical bonding material.

A method for manufacturing a display device according to the disclosure may prevent deterioration of quantum dots by minimizing impurities penetrating inside through the PWS. Therefore, the method for manufacturing the electronic device according to the disclosure may secure reliable display quality and increase luminance uniformity.

However, since this has been described above, no duplicate description is given.

The display device according to various embodiments of the disclosure may be one of various types of electronic devices. The display devices may include, for example, a portable communication device (e.g., a smartphone), a computer device, a portable multimedia device, a portable medical device, a camera, a wearable device, or a home appliance. The display devices according to an embodiment of the disclosure are not limited to the above-described devices.

It should be appreciated that various embodiments of the disclosure and the terms used therein are not intended to limit the technological features set forth herein to particular embodiments and include various changes, equivalents, or replacements for a corresponding embodiment. As used herein, the singular forms "a," "an," and "the" are intended to include the plural forms as well, unless the context clearly indicates otherwise. As used herein, the term 'and/or' should be understood as encompassing any and all possible combinations by one or more of the enumerated items. As used herein, the terms "include," "have," and "comprise" are used merely to designate the presence of the feature, component, part, or a combination thereof described herein, but use of the term does not exclude the likelihood of presence or adding one or more other features, components, parts, or combinations thereof. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another and does not limit the components in other aspect (e.g., importance or order).

As used in various embodiments of the disclosure, the term "if" may be interpreted as "when," "upon," "in response to determining," or "in response to detecting," depending on the context. Similarly, "if A is determined" or "if A is detected" may be interpreted as "upon determining A" or "in response to determining A", or "upon detecting A" or "in response to detecting A", depending on the context.

## Claims

1. A display device comprising:
a lower substrate comprising at least one light-emitting diode (LED) light source;
an upper substrate comprising at least one quantum dot color filter; and
a bonding layer configured to bond the lower substrate and the upper substrate,
wherein the upper substrate comprises a partition wall structure comprising a plurality of sub-rods repeatedly provided in an edge area of a partition wall layer.

2. The display device of claim 1, wherein the at least one of the plurality of sub-rods is configured to prevent penetration of an impurity including at least one of oxygen or moisture through the edge area.

3. The display device of claim 2, wherein the upper substrate comprises:
a glass substrate configured to output light;
a black matrix layer configured to prevent light interference;
a color filter layer comprising the at least one quantum dot color filter;
a color conversion layer comprising at least one color converter;
the partition wall layer comprising the at least one of the plurality of sub-rods; and
an inorganic encapsulation layer configured to control light reflection.

4. The display device of claim 3, wherein the lower substrate comprises:
a base substrate;
a buffer layer comprising an inorganic insulation material; and
a light-emitting element layer comprising the at least one LED light source.

5. The display device of claim 3, wherein the bonding layer comprises an optical bonding material configured to transmit light and the bonding layer is configured to bond the lower substrate and the upper substrate using the optical bonding material.

6. The display device of claim 3, wherein in the partition wall structure, the plurality of sub-rods are repeatedly provided at intervals of 1 µm to 100 µm.

7. The display device of claim 3, wherein the at least one of the plurality of sub-rods of the partition wall structure has a cubic shape and is formed to have a height of 1 µm to 100 µm.

8. The display device of claim 3, wherein the inorganic encapsulation layer fills an engraved area between at least two of the plurality of sub-rods and is parallel to the black matrix layer.

9. The display device of claim 3, wherein the upper substrate further comprises a functional planarization layer between the color filter layer and the partition wall layer, and the functional planarization layer comprises a low refractive material.

10. The display device of claim 3, wherein the plurality of sub-rods are repeatedly provided between at least two quantum dot color filters.

11. A method for manufacturing a display device, the method comprising:
forming a light-emitting substrate comprising at least one light-emitting diode (LED) light source;
forming a color conversion substrate comprising at least one quantum dot color filter; and
forming a bonding layer bonding the light-emitting substrate and the color conversion substrate,
wherein forming the color conversion substrate comprises forming a partition wall structure comprising a plurality of sub-rods repeatedly provided in an edge area of a partition wall layer.

12. The method of claim 11, wherein the at least one of the plurality of sub-rods is configured to penetration of an impurity including at least one of oxygen and moisture through the edge area.

13. The method of claim 12, wherein the forming the color conversion substrate comprises:
forming a glass substrate outputting light;
forming a black matrix layer preventing light interference;
forming a color filter layer comprising the at least one quantum dot color filter;
forming a color conversion layer comprising at least one color converter;
forming the partition wall layer comprising the at least one of the plurality of sub-rods; and
forming an inorganic encapsulation layer controlling light reflection.

14. The method of claim 13, wherein the forming the light-emitting substrate includes:
forming a base substrate;
forming a buffer layer including an inorganic insulating material; and
forming a light-emitting element layer comprising the at least one LED light source.

15. The method of claim 13, wherein the bonding layer comprises an optical bonding material transmitting light and bonds the light-emitting substrate and the color conversion substrate using the optical bonding material.
